# EUROPÄISCHE PATENTSCHRIFT

(11) **EP 2 223 354 B1**
(45) Veröffentlichungstag und Bekanntmachung des Hinweises auf die Patenterteilung: **05.07.2017**
(21) Anmeldenummer: 08864112.1
(22) Anmeldetag: 04.12.2008
(51) Int. Cl.: H01L 33/00

(54) **OPTOELEKTRONISCHES BAUELEMENT**
OPTOELECTRONIC ELEMENT
COMPOSANT OPTOÉLECTRONIQUE

(30) Priorität: 20.12.2007 DE 102007061480; 29.02.2008 DE 102008011809
(43) Veröffentlichungstag der Anmeldung: 01.09.2010
(73) Patentinhaber: Osram Opto Semiconductors Gmbh, 93055 Regensburg (DE)
(72) Erfinder: HERRMANN, Siegfried, 94362 Neukirchen (DE)
(74) Vertreter: Epping - Hermann - Fischer
(86) Internationale Anmeldenummer: PCT/DE2008/002036
(87) Internationale Veröffentlichungsnummer: WO 2009/079978

(56) Entgegenhaltungen:
- WO-A-2007/025521
- WO-A-2008/093880
- US-A- 3 991 339
- US-A1- 2003 085 654
- US-A1- 2006 273 335

## Beschreibung

Diese Patentanmeldung beansprucht die Prioritäten der deutschen Patentanmeldung 10 2007 061 480.4 und der deutschen Patentanmeldung 10 2008 011 809. 5. In der Offenlegungsschrift DE 100 40 448 A1 sind ein Halbleiterchip und ein Verfahren zur Herstellung von Halbleiterchips in Dünnschichttechnik beschrieben. Auf einem Substrat wird ein Schichtenverbund aus einer aktiven Schichtenfolge und einer Grundschicht angeordnet. Ferner werden dem Schichtenverbund eine Verstärkungsschicht und eine Hilfsträgerschicht hinzugefügt, die auf galvanischem Wege auf die Grundschicht aufgebracht werden, bevor das Substrat abgelöst wird. Auf der Seite des abgelösten Substrats wird zur Handhabung der aus dem Schichtenverbund gebildeten Halbleiterchips eine Folie auflaminiert.

Ferner ist aus der Offenlegungsschrift DE 102 34 978 A1 ein oberflächenmontierbares Halbleiterbauelement mit einem Halbleiterchip und zwei externen Anschlüssen bekannt, wobei die externen Anschlüsse an einer Folie angebracht sind.

Die Druckschrift D1 (US 2003/085654 A1) beschreibt ein elektrooptisches Bauelement und dessen Herstellung.

Die Druckschrift D2 (WO 2007/025521 A) beschreibt ein Verfahren zur Herstellung eines Halbleiterbauelements mit einer planaren Kontaktierung und ein Halbleiterbauelement.

Die Druckschrift D3 (US 2006/273335 A1) beschreibt ein lichtemittierendes Halbleiterbauelement.

Die Aufgabe, die der Erfindung zugrunde liegt, ist es, ein optoelektronisches Bauelement zu schaffen, das möglichst effizient verwendbar ist.

Die Aufgabe wird gelöst durch Merkmale des unabhängigen Patentanspruchs. Vorteilhafte Ausgestaltungen der Erfindung sind in den Unteransprüchen gekennzeichnet. Die Erfindung zeichnet sich aus durch ein optoelektronisches Bauelement mit zumindest einem Metallkörper und einer Schichtenfolge, die auf einem Grundkörper aufgebracht ist und die dazu ausgebildet ist, eine elektromagnetische Strahlung zu emittieren und bei der auf zumindest einer Seitenfläche eine Isolierung aufgebracht ist, wobei der zumindest eine Metallkörper auf zumindest einen Bereich der Isolierung aufgebracht ist und so ausgebildet ist, dass er in wärmeleitenden Kontakt steht mit dem Grundkörper, wobei in der Schichtenfolge im Betrieb Wärme erzeugt wird, die über dem Metallkörper in den Grundkörper abgeleitet wird. Während eines Beaufschlagens des optoelektronischen Bauelementes mit einem Strom, so dass eine elektromagnetische Strahlung emittiert wird, wird typischerweise immer auch eine Wärme erzeugt, die insbesonders bei optoelektronischen Bauelementen in Hochstromanwendungen zu einer geringeren Lichtausbeute und einer verminderten Betriebsdauer und sogar zu einer Zerstörung des optoelektronischen Bauelementes führen kann. Ferner kann eine hohe Wärmeerzeugung eine Wellenlängenverschiebung der emittierten elektromagnetischen Strahlung hervorrufen und somit eine Schwankung des Farbortes.

Der Grundkörper ist vorgesehen zum Aufbringen der Schichtenfolgen, die bei Beaufschlagung mit dem Strom die elektromagnetische Strahlung emittieren. Auf dem Grundkörper können eine oder mehrere Schichtenfolgen angeordnet sein. Der Grundkörper ist typischerweise als Wärmesenke ausgebildet und ist besonders geeignet, die während des Betriebes des optoelektronischen Bauelementes erzeugte Wärme abzuleiten, so dass das jeweilige optoelektronische Bauelement besonders effizient betrieben werden kann. Damit die Wärme besonders gut an den Grundkörper abgegeleitet werden kann, umfasst das optoelektronische Bauelement zumindest einen Metallkörper, der mit dem Grundkörper in wärmeleitenden Kontakt steht. Damit mittels des Metallkörpers kein Kurzschluss erzeugt wird, ist auf zumindest einer Seitenfläche der Schichtenfolge eine Isolierung aufgebracht, die bevorzugt elektrisch isolierend ausgebildet ist und die Schichtenfolge vor Verschmutzungen beispielsweise während eines Vereinzelns der optoelektronischen Bauelemente schützt. Der Metallkörper kann einer oder mehreren Seitenflächen des optoelektronischen Bauelementes zugeordnet sein. Dadurch kann, je nach Anforderung an die Wärmeableitung des jeweiligen optoelektronischen Bauelementes, die Wärme besonders geeignet abgeleitet werden und das optoelektronische Bauelement besonders effizient betrieben werden.

In einer vorteilhaften Ausgestaltung ist die Isolierung als Isolationsschicht oder als Isolationsschichtenfolge ausgebildet.

Dadurch kann besonders sicher eine elektrische Isolierung zwischen dem Metallkörper und der Schichtenfolge gewährleistet werden. Ferner kann mittels der Isolationsschicht oder mittels der Isolationsschichtenfolge ein sicherer Schutz vor Verschmutzungen der Schichtenfolge gewährleistet werden.

In einer weiteren vorteilhaften Ausgestaltung weist die Isolationsschicht oder die Isolationsschichtenfolge eine Passivierungschicht und/oder zumindest eine Luftschicht auf.

Die als Passivierungsschicht ausgebildete Isolationsschicht oder Isolationsschichtenfolge ist bevorzugt elektrisch isolierend ausgebildet, so dass mittels des Metallkörpers kein Kurzschluss erzeugt werden kann. Des Weiteren schützt die Passivierungsschicht die Schichtenfolge vor Verschmutzungen beispielsweise während eines Vereinzelns der optoelektronischen Bauelemente.

Die Luftschicht kann zwischen der Passivierungsschicht und der Schichtenfolge und/oder zwischen der Passivierungsschicht und dem Metallkörper angeordnet sein, so dass der Metallkörper elektrisch isoliert ist von der Schichtenfolge, so dass Kurzschlüsse sicher vermieden werden können.

In einer weiteren vorteilhaften Ausgestaltung ist der Metallkörper als Metallmaske ausgebildet.

Dabei ist die Metallmaske derart ausgebildet, dass sie eine Ausnehmung für die jeweilige Schichtenfolge des optoelektronischen Bauelementes aufweist, so dass der als Metallmaske ausgebildete Metallkörper die Schichtenfolge umfassen kann. Bevorzugt ist die Metallmaske als ringförmiger Metallkörper ausgebildet. Derart kann sie beispielsweise auf die als Isolationsschicht oder Isolationsschichtenfolge ausgebildete Isolierung der jeweiligen Seitenfläche der Schichtenfolge aufgebracht werden, so dass die erzeugte Wärme in der Schichtenfolge besonders gut an den Grundkörper abgeleitet werden kann. Bevorzugt kann die Metallmaske mehrere Ausnehmungen für einen Verbund von Schichtenfolgen aufweisen und somit gleichzeitig auf den Verbund von Schichtenfolgen aufgebracht werden, so dass die jeweiligen optoelektronischen Bauelemente besonders kostengünstig hergestellt werden können.

In einer weiteren vorteilhaften Ausgestaltung ist der Metallkörper mittels eines galvanischen Verfahrens hergestellt.

Mittels des galvanischen Verfahrens kann der Metallkörper besonders geeignet auf die jeweilige Isolierung der Schichtenfolge aufgebracht werden, so dass der Metallkörper in wärmeleitenden Kontakt steht mit dem Grundkörper. Dadurch kann die durch den Betrieb des optoelektronischen Bauelementes erzeugte Wärme gut abgeführt werden und somit das optoelektronische Bauelement besonders effizient betrieben werden.

In einer weiteren vorteilhaften Ausgestaltung ist auf zumindest einen Bereich einer dem Grundkörper abgewandten Oberfläche der Schichtenfolge eine Stromverteilungsstruktur aufgebracht.

Die Stromverteilungsstruktur stellt typischerweise eine elektrische Kopplung zur Schichtenfolge des optoelektronischen Bauelementes dar. Die Stromverteilungsstruktur kann beispielsweise mittels photolithographischen Verfahrens und/oder galvanischen Verfahrens auf die dem Grundkörper abgewandte Oberfläche der Schichtenfolge aufgebracht sein. Dabei ist die Stromverteilungsstruktur derart über die jeweilige Oberfläche der Schichtenfolge aufgebracht, so z.B. in einer quadratischen oder rechteckigen Struktur, dass ein während des Betriebes des optoelektronischen Bauelementes zugeführter Strom besonders homogen in die Schichtenfolge eingebracht werden kann, so dass das optoelektronische Bauelement besonders effizient betrieben werden kann. Eine derartig ausgebildete Stromverteilungsstruktur auf der dem Grundkörper abgewandten Oberfläche der Schichtenfolge ist besonders geeignet für großflächige optoelektronische Bauelemente für Hochstromanwendungen.

In einer weiteren vorteilhaften Ausgestaltung steht der zumindest eine Metallkörper elektrisch leitend mit der Stromverteilungsstruktur und mit einem elektrischen Anschlussbereich zum elektrischen Kontaktieren des optoelektronischen Bauelementes in Kontakt.

Durch die weitere Nutzung des Metallkörpers als elektrisch leitende Verbindung zwischen der Stromverteilungsstruktur und dem elektrischen Anschlussbereich zum elektrischen Kontaktieren des optoelektronischen Bauelementes, kann das optoelektronische Bauelement besonders kostengünstig hergestellt werden. Dabei stellt der elektrische Anschlussbereich, der mittels des Metallkörpers mit der Stromverteilungsstruktur auf der Oberfläche der Schichtenfolge gekoppelt ist, einen zweiten elektrischen Anschlussbereich des optoelektronischen Bauelementes dar. Ein erster elektrischer Anschlussbereich ist typischerweise der der Grundfläche zugewandten Oberfläche der Schichtenfolge zugeordnet. Dabei ist die jeweilige Isolierung bevorzugt derart ausgebildet, dass sie elektrisch isolierend zwischen dem ersten und zweiten elektrischen Anschlussbereich angeordnet ist, so dass ein Kurzschluss vermieden wird.

In einer weiteren vorteilhaften Ausgestaltung ist der Grundkörper als Keramikkörper, als passivierter Siliziumkörper oder als passivierter metallischer Körper ausgebildet.

Eine derartige Ausbildung des Grundkörpers ist besonders geeignet als Wärmesenke und somit zum Ableiten der während des Betriebes des optoelektronischen Bauelementes erzeugten Wärme. Das hergestellte optoelektronische Bauelement umfassend den als Wärmesenke ausgebildeten Grundkörper kann in bevorzugten Anwendungen derart angeordnet sein, dass der Grundkörper mit anderen Körpern aus geeigneten wärmeleitenden Material gekoppelt ist, so dass das optoelektronische Bauelement besonders effizient betrieben werden kann. Typischerweise sind elektrisch leitende Grundkörper mittels einer Passivierungsschicht, die geeignet wärmeleitend ausgebildet ist, beschichtet, auf die die Schichtenfolge und/oder die elektrischen Anschlussbereiche aufgebracht werden können.

In einer weiteren vorteilhaften Ausgestaltung weist der zumindest eine Metallkörper zumindest einen der Bestandteile Au, Ag oder Ni auf.

Derartige Materialien eignen sich besonders zum Abführen von Wärme und gleichzeitig als elektrischer Leiter. Bei geeigneter Kopplung des Metallkörpers mit dem Grundkörper, kann das optoelektronische Bauelement besonders kostengünstig hergestellt werden und besonders effizient betrieben werden.

In einer weiteren vorteilhaften Ausgestaltung ist der zumindest eine Metallkörper als Reflektor ausgebildet, zum Reflektieren der elektromagnetischen Strahlung in eine vorgegebene Abstrahlrichtung.

Der Metallkörper kann als Gehäuse der Schichtenfolge derart ausgebildet sein, dass mittels seiner Kanten eine Reflektion der emittierten elektromagnetischen Strahlung in eine vorgegebene Abstrahlrichtung gewährleistet werden kann. Durch diese Ausbildung des Metallkörpers kann die Abstrahlcharakteristik des optoelektronischen Bauelementes besonders vorteilhaft beeinflusst werden. Ein derartig ausgebildetes optoelektronisches Bauelement zeichnet sich durch eine kostengünstige Herstellung und eine hohe Effizienz aus.

In einer weiteren vorteilhaften Ausgestaltung weist das optoelektronische Bauelement eine Konverterschicht mit zumindest einem Leuchtstoff auf, die auf zumindest einem Bereich der dem Grundkörper abgewandten Oberfläche der Schichtenfolge aufgebracht ist und mit dem zumindest einen Metallkörper in wärmeleitenden Kontakt steht.

Die Konverterschicht ist typischerweise als Lumineszenzkonversionsschicht mit mindestens einem Leuchtstoff ausgebildet. Der Leuchtstoff ist durch die von dem optoelektronischen Bauelement emittierte elektromagnetische Strahlung, die auch als elektromagnetische Primärstrahlung bezeichnet werden kann, anregbar und emittiert eine Sekundärstrahlung. Die Primärstrahlung und die Sekundärstrahlung weisen dabei unterschiedliche Wellenlängenbereiche auf. Ein gewünschter resultierender Farbort des optoelektronischen Bauelementes kann beispielsweise durch ein Einstellen eines Mischungsverhältnisses der Primärstrahlung und der Sekundärstrahlung eingestellt werden. Typischerweise weist die Konverterschicht zumindest ein Material aus der Gruppe bestehend aus Silikonen, Siloxanen, Spin-on Oxiden und photostrukturierbaren Materialien auf. Der zumindest eine Leuchtstoff ist beispielsweise als organischer Leuchtstoff und/oder liegt teilweise als Nanopartikel vor.

Die Leuchtstoffe können aufgrund der Anregung durch die Primärstrahlung, insbesonders bei einer UV-Primärstrahlung sehr stark erwärmt werden und somit die Konverterschicht stark erwärmen. Durch die wärmeleitende Kopplung des Metallkörpers mit einer derartigen Konverterschicht, kann die erzeugte Wärme in der Konverterschicht besonders gut an den als Wärmesenke ausgebildeten Grundkörper abgeführt werden und somit das optoelektronische Bauelement besonders effizient betrieben werden. Ferner kann eine Farbortschwankung unterbunden werden und somit die Abstrahlcharakteristik des optoelektronischen Bauelementes besonders vorteilhaft beeinflusst werden.

Ausführungsbeispiele der Erfindung sind im Folgenden anhand der schematischen Zeichnungen näher erläutert. Es zeigen:
- Figur 1: schematische Schnittansichten eines optoelektronischen Bauelements,
- Figuren 2A, 2B: jeweils eine weitere schematische Schnittansicht eines optoelektronischen Bauelementes,
- Figur 3: eine schematische Draufsicht eines optoelektronischen Bauelementes,
- Figur 4: eine weitere schematische Schnittansicht eines optoelektronischen Bauelementes mit Metallmaske,
- Figur 5: eine schematische Darstellung eines Verbundes mehrerer optoelektronischer Bauelemente.

In den Ausführungsbeispielen und Figuren sind gleiche oder gleichwirkende Bestandteile jeweils mit gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

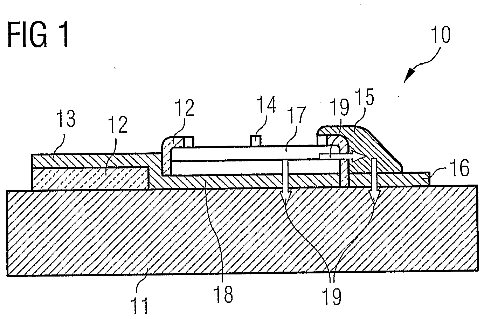

In Figur 1 ist ein optoelektronisches Bauelement 10 dargestellt, das beispielsweise als Lumineszenzdiode ausgebildet ist. Das optoelektronische Bauelement 10 umfasst einen Grundköper 11, der beispielsweise als Keramikkörper oder als passivierter metallischer Körper oder als passivierter Siliziumkörper ausgebildet ist. Der Grundkörper 11 ist bevorzugt als Wärmesenke mit geringem Wärmeleitwiderstand ausgebildet und weist typischerweise eine geringe Dicke auf, so z.B. 100 µm, wodurch eine geringe Bauhöhe des optoelektronischen Bauelementes erzielt werden kann. Insbesondere ist der Grundkörper eine Folie. Der Grundkörper 11 dient als Träger für eine Schichtenfolge 17, die dazu ausgebildet ist, bei Beaufschlagung mit elektrischem Strom eine elektromagnetische Strahlung zu emittieren. Die Schichtenfolge 17 ist beispielsweise als Dünnfilmschicht ausgebildet.

Die Dünnfilmschicht basiert beispielsweise auf Nitrid-Verbindungshalbleitermaterialien und weist mindestens einen aktiven Bereich auf, der geeignet ist, die elektromagnetische Strahlung zu emittieren. Die elektromagnetische Strahlung weist beispielsweise Wellenlängen aus dem blauen und/oder ultravioletten Spektrum auf. Dabei ist die Schichtenfolge 17 typischerweise auf einem separaten Aufwachssubstrat aufgewachsen, nachfolgend von diesem abgelöst sowie auf den Grundkörper 11 aufgebracht worden. Die Ablösung kann mittels eines Laserablöseverfahrens erfolgen, wie es beispielsweise aus der WO 98/14986 bekannt ist, deren Inhalt hiermit diesbezüglich einbezogen ist. Alternativ kann die Ablösung durch Ätzen oder ein sonstiges geeignetes Abhebeverfahren erfolgen.

Nitrid-Verbindungshalbleitermaterialien sind Verbindungshalbleitermaterialien, die Stickstoff enthalten, wie Materialien aus dem System InₓAl_{y}Ga_{1-x-y}N mit 0 ≤ x ≤ 1, 0 ≤ y ≤ 1 und x + y ≤ 1. Die Dünnfilmschicht weist z.B. mindestens eine Halbleiterschicht aus einem Nitrid-Verbindungshalbleitermaterial auf.

In dem aktiven Bereich der Schichtenfolge 17 kann beispielsweise ein herkömmlicher pn-Übergang, eine Doppelheterostruktur, eine Einfach-Quantentopfstruktur (SQW-Struktur) oder eine Mehrfach-Quantentopfstruktur (MQW-Strukur) enthalten sein. Solche Strukturen sind dem Fachmann bekannt und werden von daher an dieser Stelle nicht näher erläutert.

Die Schichtenfolge 17 weist an deren Seitenflächen eine als Isolationsschicht ausgebildete Isolierung 12 auf, die beispielsweise als Passivierungsschicht ausgebildet ist und als Bestandteil beispielsweise SiO₂ aufweist. Ferner kann die Isolierung 12 als eine auf die Schichtenfolge 17 aufgebrachte Lackschicht ausgebildet sein. Die Isolierung 12 weist bevorzugt elektrisch isolierende Eigenschaften auf, d.h. einen besonders hohen elektrischen Widerstand. Die als Passivierungsschicht ausgebildete Isolierung 12 kann direkt mit den Seitenflächen der Schichtenfolge 17 in Kontakt stehen. Alternativ kann die Schichtenfolge 17 an deren Seitenflächen eine als Isolationsschichtenfolge ausgebildete Isolierung 12 aufweisen. Diese kann neben der Passivierungsschicht zumindest eine weitere Schicht aufweisen, so z.B. eine Luftschicht und/oder eine Lackschicht, die beispielsweise zwischen den Seitenflächen der Schichtenfolge 17 und der Passivierungsschicht angeordnet ist.

Zwischen der Schichtenfolge 17 und dem Grundkörper 11 ist eine reflektierende elektrische Kontaktstruktur 18 angeordnet, die mit einem ersten elektrischen Anschlussbereich 13 elektrisch gekoppelt ist. An der reflektierenden elektrischen Kontaktstruktur 18 wird die von der Schichtenfolge 17 emittierte elektromagnetische Strahlung reflektiert. Der erste elektrische Anschlussbereich 13 ist auf einer weiteren Isolationsschicht 12, die beispielsweise als Passivierungsschicht ausgebildet ist, auf den Grundkörper 11 aufgebracht. Der erste elektrische Anschlussbereich 13 kann aber auch ohne weitere Isolierung 12 auf den Grundkörper 11 aufgebracht werden.

Die Schichtenfolge 17 ist mittels der reflektierenden elektrischen Kontaktstruktur 18 auf den Grundkörper 11 gelötet oder geklebt, wobei der Grundkörper 11 bevorzugt elektrisch isolierend ausgebildet ist, d.h. einen besonders hohen elektrischen Widerstand aufweist. Alternativ kann die Schichtenfolge 17 aber auch mittels eines elektrisch isolierenden Lots oder einer Passivierungsschicht zwischen reflektierender elektrischer Kontaktstruktur 18 und Grundkörper 11 auf diesen aufgebracht sein.

Auf einer dem Grundkörper 11 abgewandten Oberfläche der Schichtenfolge 17 ist eine Stromverteilungsstruktur 14 aufgebracht. Diese ist typischerweise metallisch, so z.B. aus Au oder Ag, auf der Oberfläche der Schichtenfolge 17 ausgebildet. Typischerweise verläuft die Stromverteilungsstruktur 14 in Form von Kontaktstegen über die Oberfläche der Schichtenfolge 17. Bevorzugt bilden die Kontaktstege die Umrisse mehrerer Rechtecke oder Quadrate aus. Besonders bevorzugt weisen die mehreren Rechtecke oder Quadrate jeweils zumindest eine gemeinsame Seitenkante (in Figur 1 nicht dargestellt), besonders bevorzugt sogar zwei gemeinsame Seitenkanten, auf. Insbesondere können die Kontaktstege den Umriss mehrerer Quadrate und/oder Rechtecke ausbilden, die jeweils einen gemeinsamen Eckpunkt aufweisen. Die Stromverteilungsstruktur 14 ist dazu ausgebildet, bei Beaufschlagung mit einem Strom, diesen homogen in die Schichtenfolge 17 einzubringen, um eine möglichst homogene Stromverteilung in der Schichtenfolge 17 zu gewährleisten. Mittels derartiger Stromverteilungsstrukturen 14 kann eine besonders homogene Abstrahlcharakteristik des jeweiligen optoelektronischen Bauelementes 10 erreicht werden, insbesondere wenn diese besonders großflächig, so z.B. > 1 mm², ausgebildet ist.

Neben der reflektierenden elektrischen Kontaktstruktur 18 ist auf dem Grundkörper 11 ein zweiter elektrischer Anschlussbereich 16 aufgebracht, der mit der Stromverteilungsstruktur 14 mittels eines Metallkörpers 15 elektrisch gekoppelt ist. Der Metallkörper 15 ist auf zumindest einem Bereich der Isolierung 12 der Schichtenfolge 17 aufgebracht und weist beispielsweise eine Passivierungsschicht auf. Alternativ kann der Metallkörper 15 aber auch auf zumindest einen Bereich einer als Isolationsschichtenfolge ausgebildeten Isolierung 12 aufgebracht werden, die beispielsweise eine Passivierungsschicht und eine Luftschicht aufweist. Der Metallkörper 15 ist beispielsweise mittels eines galvanischen Verfahrens auf den zweiten Anschlussbereich 16 und/oder der Isolierung 12 aufgebracht. Grundsätzlich sind aber auch andere einem Fachmann bekannte Verfahren zum Aufbringen des Metallkörpers 15 einsetzbar. Der Metallkörper 15 kann dabei direkt auf zumindest einen Bereich der als Passivierungsschicht ausgebildeten Isolierung 12 aufgebracht sein. Zwischen dem Metallkörper 15 und der Passivierungsschicht kann aber auch eine weitere Schicht zumindest bereichsweise angeordnet sein, so z.B. eine Luftschicht. Der Metallkörper 15 enthält typischerweise Bestandteile von Au, Ag, oder Ni und zeichnet sich somit durch einen geringen Wärmeleitwiderstand, sowie einen geringen elektrischen Widerstand aus. Der Metallkörper 15 ist mittels des zweiten Anschlussbereiches 16 wärmeleitend mit dem Grundkörper 11 gekoppelt.

Beispielsweise werden der erste und zweite elektrische Anschlussbereich 13 und 16 entweder unter Verwendung einer Schablone aufgedruckt oder vollflächig aufgebracht und nachfolgend mittels Photolithographie in gewünschter Weise strukturiert. Vorzugsweise wird der erste und zweite Anschlussbereich 13 und 16 aus einem Metall oder einer Metallverbindung gebildet. Insbesondere enthält der erste und zweite Anschlussbereich 13 und 16 Au oder Ag.

Die während eines Betriebs des optoelektronischen Bauelementes 10 erzeugte Wärme kann senkrecht zur Schichtenfolge 17 in den Grundkörper 11 abgeleitet werden und zusätzlich mittels des Metallkörpers 15 lateral zur Schichtenfolge 17 in den Grundkörper 11 abgeleitet werden (siehe Pfeile 19). Dabei kann der Metallkörper 15 abhängig von der jeweiligen Anforderung der Wärmeableitung des optoelektronischen Bauelementes 10 mehr oder weniger großvolumig ausgebildet sein. Insbesonders bei optoelektronischen Bauelementen 10 für Hochstromanwendungen, die beispielsweise Kantenlänge von 1 mm aufweisen und bei einer Versorgungsspannung von 3 V bis 4 V beispielsweise einen Strom von 1 A zum Betrieb benötigen, ist der Metallkörper 15 besonders großvolumig und großflächig mit dem zweiten Anschlussbereich 16 gekoppelt, um die erzeugte Wärme besonders effizient an den Grundkörper 11 abzuführen.

Die reflektierende elektrische Kontaktstruktur 18 und der zweite elektrische Anschlussbereich 16 sind mittels der Isolierung 12 elektrisch voneinander isoliert, so dass ein Kurzschluss zwischen den beiden Anschlussbereichen vermieden werden kann.

Grundsätzlich kann das optoelektronische Bauelement 10 auch derart ausgebildet sein, dass die Stromverteilungsstruktur 14 nicht mittels des Metallkörpers 15 mit dem zweiten elektrischen Anschlussbereich 16 gekoppelt ist. In derartigen Ausbildungen wird der Metallkörper 15 typischerweise nur zur Wärmeableitung verwendet und kann somit auch direkt auf den Grundkörper 11 aufgebracht werden, so dass eine besonders hohe Wärmeableitung gewährleistet ist.

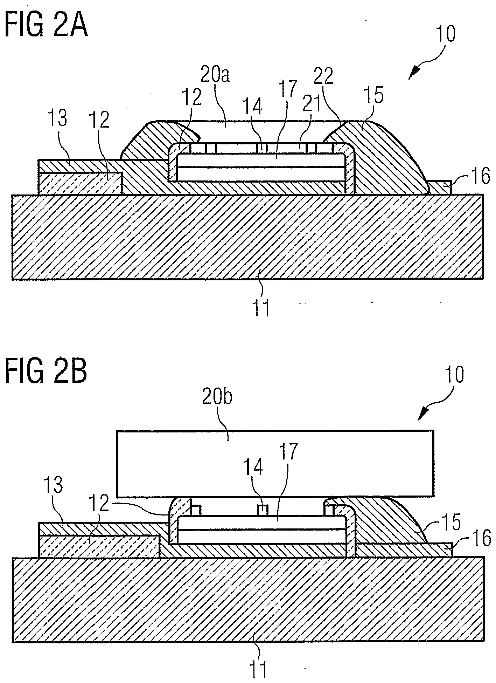

In Figur 2A ist ein weiteres Ausführungsbeispiel eines optoelektronischen Bauelements 10 dargestellt mit einem Metallkörper 15, der als Metallumrandung ausgebildet alle vier Seitenflächen der Schichtenfolge 17 umrandet (in Figur 2A sind nur die linke und rechte Seitenfläche dargestellt), wobei der Metallkörper 15 nicht elektrisch gekoppelt ist mit der Stromverteilungsstruktur 14 auf der dem Grundkörper 11 abgewandten Oberfläche der Schichtenfolge 17. Alternativ kann die Stromverteilungsstruktur 14 mittels Bonddrahts mit dem zweiten elektrischen Anschlussbereich 16 elektrisch gekoppelt sein (nicht dargestellt), wobei der Bonddraht beispielsweise einem Eckpunkt zumindest eines Rechtecks oder Quadrats, dessen Umriss durch die Kontaktstege ausgebildet wird, zugeordnet ist. Insbesondere kann der Bonddraht einem gemeinsamen Eckpunkt mehrerer Quadrate und/oder Rechtecke zugeordnet sein. Durch die wärmeleitende Kontaktierung des Metallkörpers 15 an mehreren Seitenflächen der Schichtenfolge 17, kann die Effizienz der lateralen Wärmeableitung in den Grundkörper 11 noch erhöht werden, wobei darauf zu achten ist, dass der Metallkörper 15 nicht zugleich elektrisch gekoppelt ist mit dem ersten und zweiten elektrischen Anschlussbereich 13 und 16.

Das optoelektronische Bauelement 10 zeichnet sich ferner dadurch aus, dass es eine als Lumineszenzkonversionsschicht ausgebildete Konverterschicht 20a umfasst mit mindestens einem Leuchtstoff. Als Leuchtstoff sind beispielsweise anorganische Leuchtstoffe geeignet, die mit seltenen Erden, insbesondere mit Ce oder Tb, dotierte Granate, die bevorzugt eine Grundstruktur A₃B₅O₁₂ aufweisen, oder organische Leuchtstoffe, wie Perylen-Leuchtstoffe.

Die Konverterschicht 20a ist mittels einer transparenten Zwischenschicht 21 mit der dem Grundkörper 11 abgewandten Oberfläche der Schichtenfolge 17 gekoppelt. Typischerweise ist die transparente Zwischenschicht als Passivierungsschicht ausgebildet. Die transparente Zwischenschicht 21 ist bevorzugt wärmeleitend, d.h. mit einem geringen Wärmeleitwiderstand, ausgebildet und ferner wärmeleitend mit dem Metallkörper 15 gekoppelt. Eine derartige Ausbildung des optoelektronischen Bauelementes 10 ist besonders geeignet, die erzeugte Wärme der Schichtenfolge 17 abzuführen und eine von dem Leuchtstoff der Konverterschicht 20a erzeugte Wärme, die während der Umwandlung von der Primärstrahlung in die Sekundärstrahlung erzeugt wird, insbesondere bei einer Primärstrahlung im UV-Wellenlängenbereich, zum Grundkörper 11 abzuleiten.

In einem weiteren vorteilhaften Ausführungsbeispiel ist der Metallkörper 15 derart ausgebildet und geformt, dass er an den Metallkörper-Kanten 22, die der Hauptabstrahlrichtung der emittierten elektromagnetischen Strahlung der Schichtenfolge 17 zugeordnet sind, reflektierend wirkt und somit die Abstrahlcharakteristik des optoelektronischen Bauelementes 10 vorteilhaft beeinflusst.

Der Metallkörper 15 stellt ein Gehäuse des optoelektronischen Bauelementes 10 dar, auf das zusätzliche optische Elemente und/oder Schichten, wie z.B. optische Linsen und/oder Abdeckschichten mit strahlformenden Eigenschaften aufgebracht werden können.

Beispielsweise ist in dem in Figur 2B dargestellten Ausführungsbeispiel eine Konverterkeramik 20b auf dem Metallkörper 15 aufgebracht. Eine Konverterkeramik ist insbesondere eine Grundplatte, umfassend als Grundmaterial beispielsweise eine Keramik, in der ein Leuchtstoff eingebracht ist, der Primärstrahlung einer ersten Wellenlänge absorbiert und in Sekundärstrahlung einer weiteren, von der ersten Wellenlänge verschiedenen Wellenlänge umwandelt. Als Leuchtstoff sind beispielsweise oben genannte anorganische Leuchtstoffe geeignet.

Der Metallkörper 15 dient in dem Ausführungsbeispiel der Figur 2B als Stützträger der Konverterkeramik 20b. Ferner kann mit Vorteil über den Metallkörper 15 eine von dem Leuchtstoff der Konverterkeramik 20b erzeugte Wärme, die während der Umwandlung von der Primärstrahlung in die Sekundärstrahlung erzeugt wird, insbesondere bei einer Primärstrahlung im UV-Wellenlängenbereich, zum Grundkörper 11 abgeleitet werden.

Zwischen der Konverterkeramik 20b und der Schichtenfolge 17 kann Luft angeordnet sein. Luft weist eine niedrige Wärmeleitfähigkeit auf, sodass eine thermische Isolierung zwischen der Konverterkeramik 20b und der Schichtenfolge 17 erzielt werden kann. Alternativ kann die Konverterschicht 20b entsprechend dem Ausführungsbeispiel der Figur 2A mittels einer transparenten Zwischenschicht mit der dem Grundkörper 11 abgewandten Oberfläche der Schichtenfolge 17 verbunden sein.

Im Übrigen stimmt das Ausführungsbeispiel der Figur 2B mit dem Ausführungsbeispiel der Figur 1 überein.

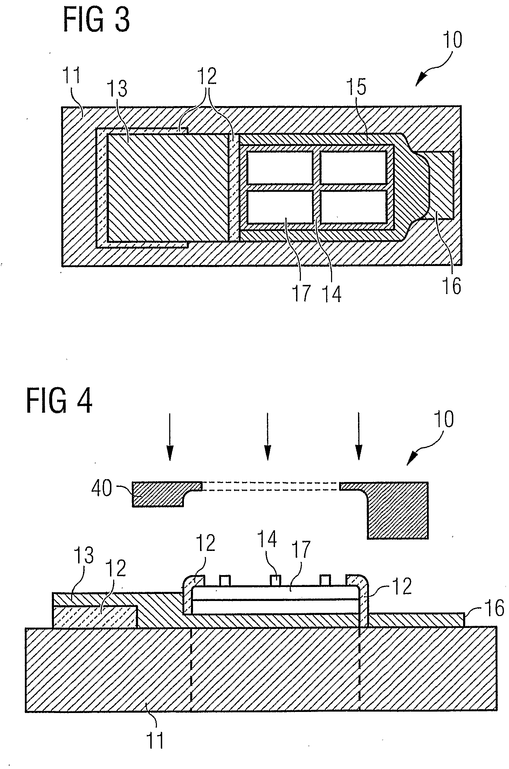

In Figur 3 ist eine Draufsicht auf ein optoelektronisches Bauelement 10 dargestellt. Auf dem Grundkörper 11 sind der erste und zweite elektrische Anschlussbereich 13 und 16 des optoelektronischen Bauelementes 10 aufgebracht. Der erste elektrische Anschlussbereich 13 ist mit der reflektierenden elektrischen Kontaktstruktur 18 elektrisch gekoppelt (nicht dargestellt). Der zweite elektrische Anschlussbereich 16 ist mittels des Metallkörpers 15 mit der Stromverteilungsstruktur 14 elektrisch gekoppelt. Die Stromverteilungsstruktur 14 ist als rechteckige Struktur auf die dem Grundkörper abgewandten Oberfläche der Schichtenfolge 17 aufgebracht, so z.B. mittels eines galvanischen Verfahrens. Mittels der rechteckig angeordneten Stromverteilungsstruktur 14 kann der Strom besonders homogen der Schichtenfolge 17 zugeführt werden, um eine besonders homogene Abstrahlcharakteristik, insbesonders bei großflächigen optoelektronischen Bauelementen zu gewährleisten. Die Stromverteilungsstruktur 14 kann alternativ aber auch quadratisch oder in Form von konzentrischen Quadraten und/oder Rechtecken mit zumindest einem gemeinsamen Eckpunkt angeordnet sein.

Der Grundkörper 15 umschließt die Schichtenfolge 17 an drei Seitenflächen und gewährleistet dadurch eine besonders gute Wärmeableitung in den Grundkörper 11. Auch eine Umrandung aller vier Seitenflächen der Schichtenfolge 17 ist möglich.

In Figur 4 ist ein weiteres optoelektronisches Bauelement 10 dargestellt mit der Schichtenfolge 17 und einer darauf aufgebrachten Stromverteilungsstruktur 14. Die Figur 4 zeigt ein weiteres Ausführungsbeispiel bei dem der Metallkörper 15 nicht galvanisch aufgebracht wird, sondern als Metallmaske ausgebildet auf die Isolierung 12 der Schichtenfolge 17 aufgebracht wird. Der als Metallmaske ausgebildete Metallkörper 15 umfasst typischerweise eine Ausnehmung in Form der Schichtenfolge 17 und kann direkt auf die Isolierung 12 der Schichtenfolge 17 aufgebracht, so z.B. aufgelötet oder geklebt, werden. Der als Metallmaske ausgebildete Metallkörper 15 kann derart ausgebildet sein, dass nur jeweils eine Seitenfläche der Schichtenfolge 17 mit dem Metallkörper 15 bedeckt wird. Die Metallmaske kann aber auch ringförmig ausgebildet sein, so dass mehr als eine Seitenfläche mittels des Metallkörpers 15 bedeckt ist. Das Aufbringen des als Metallmaske ausgebildeten Metallkörpers 15 ist besonders dann vorteilhaft, wenn die Metallmaske mehrere Ausnehmungen in Form der Schichtenfolge 17 aufweist und somit ein Verbund von Schichtenfolgen 17 von optoelektronischen Bauelementen 10 auf beispielsweise einem gemeinsamen Grundkörper 11 mit einem Metallkörper 15 versehen werden. Eine derartige Herstellung von optoelektronischen Bauelementen ist besonders kostengünstig.

In einem weiteren Ausführungsbeispiel kann das optoelektronische Bauelement 10 derart ausgebildet sein, dass der erste elektrische Anschlussbereich 13 mittels einer nicht-reflektierenden elektrischen Kontaktstruktur 18 mit der dem Grundkörper 15 zugeordneten Oberfläche der Schichtenfolge gekoppelt ist. Ferner kann der Grundkörper 11 im Bereich der Schichtenfolge 17 (gestrichelten Linien in Figur 4) transparent, so z.B. mit Glas, oder mit einer Ausnehmung in Form der Schichtenfolge 17 ausgebildet sein, so dass das optoelektronische Bauelement 10 die elektromagnetische Strahlung in eine dem Grundkörper 11 abgewandten Abstrahlrichtung emittiert und eine dem Grundkörper 11 zugewandten Abstrahlrichtung emittiert. Auch bei einer derartigen Ausbildung des optoelektronischen Bauelementes 10 ist sichergestellt, dass die Wärme lateral mittels des Metallkörpers 15 in den Grundkörper 11 abgeleitet wird.

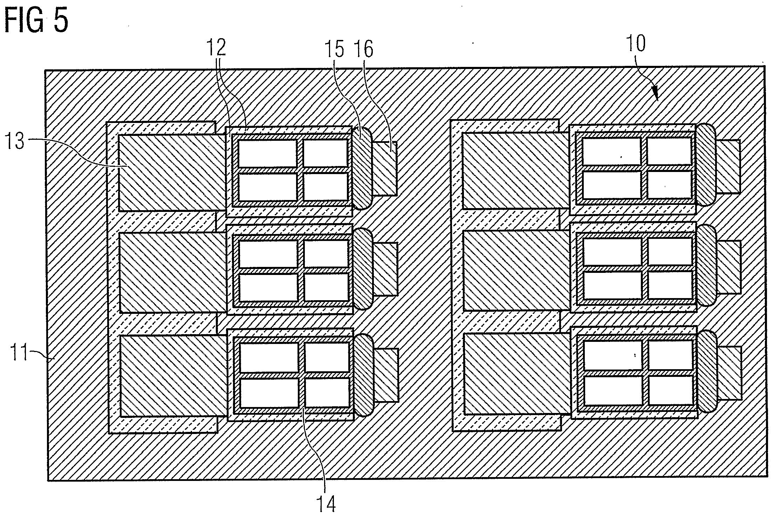

In Figur 5 ist eine Draufsicht eines Verbundes mehrerer optoelektronischer Bauelemente 10 auf einem Grundkörper 11 dargestellt. Jeder der dargestellten optoelektronischen Bauelemente 10 umfasst den ersten und zweiten elektrischen Anschlussbereich 13 und 16. Je nach Anforderung, können die einzelnen optoelektronischen Bauelemente 10 elektrisch zusammengeschaltet werden, so z.B. in Reihenschaltung. Die elektrische Kontaktierung der jeweiligen optoelektronischen Bauelemente 10 kann beispielsweise mittels photolithographischen Verfahrens erfolgen. Auch ein als Metallmaske ausgebildeter Metallkörper 15, der eine Mehrzahl von Ausnehmungen für alle Schichtenfolgen 17 des Verbundes von optoelektronischen Bauelementen 10 aufweist, ist denkbar.

Jeder der optoelektronischen Bauelemente 10 umfasst jeweils einen Metallkörper 15 auf einer als Isolationsschicht oder als Isolationsschichtenfolge ausgebildeten Isolierung 12. Durch eine derartige Ausbildung der einzelnen optoelektronischen Bauelemente 10 ist die benötigte Fläche des jeweiligen optoelektronischen Bauelementes 10 besonders gering und somit kann die Bauelementdichte auf einem vorgegebenen Grundkörper 11 besonders hoch ausgelegt werden. Grundsätzlich kann der Metallkörper 15 aber auch ringförmig um die Schichtenfolge 17 ausgebildet sein.

Die in Figur 5 dargestellten optoelektronischen Bauelemente 10 sind rechteckig ausgebildet. Aber auch andere Formen der optoelektronischen Bauelemente 10 sind denkbar, so z.B. eine sechseckige Form oder eine runde Form. Insbesondere im Hinblick auf eine optimale Wärmeableitung und/oder eine optimale Nutzung der vorgegebenen Fläche des Grundkörpers 11 ist zu entscheiden, welche Form am geeignetsten auszubilden ist.

Ferner kann der in Figur 5 dargestellte Verbund von optoelektronischen Bauelementen 10 mit zusätzlichen elektronischen Bauelementen bestückt werden, so z.B. Kondensatoren, Widerständen und/oder Induktivitäten. Die zusätzlichen elektronischen Bauelemente können zu einer vorgegebenen Schaltungsanordnung zur Ansteuerung der optoelektronischen Bauelemente angeordnet sein, so z.B. zur Strombegrenzung oder Helligkeitssteuerung.

## Patentansprüche

1. Optoelektronisches Bauelement (10) mit zumindest einem Metallkörper (15) und einer Schichtenfolge (17), die auf einem Grundkörper (11) aufgebracht ist und die dazu ausgebildet ist, eine elektromagnetische Strahlung zu emittieren und bei der auf zumindest einer Seitenfläche eine Isolierung (12) aufgebracht ist, wobei der zumindest eine Metallkörper (15) auf zumindest einen Bereich der Isolierung (12) aufgebracht ist und so ausgebildet ist, dass er in wärmeleitenden Kontakt steht mit dem Grundkörper (11), wobei in der Schichtenfolge (17) im Betrieb Wärme erzeugt wird, die über dem Metallkörper (15) in den Grundkörper (11) abgeleitet wird.

2. Optoelektronisches Bauelement (10) nach Anspruch 1, bei dem die Isolierung (12) als Isolationsschicht oder als Isolationsschichtenfolge ausgebildet ist.

3. Optoelektronisches Bauelement (10) nach Anspruch 2, bei dem die Isolationsschicht oder die Isolationsschichtenfolge eine Passivierungsschicht und/oder zumindest eine Luftschicht aufweist.

4. Optoelektronisches Bauelement (10) nach einem der vorstehenden Ansprüche, bei dem der zumindest eine Metallkörper (15) als Metallmaske (40) ausgebildet ist.

5. Optoelektronisches Bauelement (10) nach einem der vorstehenden Ansprüche, bei dem der zumindest eine Metallkörper (15) mittels eines galvanischen Verfahrens hergestellt ist.

6. Optoelektronisches Bauelement (10) nach einem der vorstehenden Ansprüche, bei dem auf zumindest einen Bereich einer dem Grundkörper (11) abgewandten Oberfläche der Schichtenfolge (17) eine Stromverteilungsstruktur (14) aufgebracht ist.

7. Optoelektronisches Bauelement (10) nach Anspruch 6, bei dem der zumindest eine Metallkörper (15) elektrisch leitend mit der Stromverteilungsstruktur (14) und mit einem elektrischen Anschlussbereich (16) zum elektrischen Kontaktieren des optoelektronischen Bauelementes (10) in Kontakt steht.

8. Optoelektronisches Bauelement (10) nach einem der vorstehenden Ansprüche, bei dem der Grundkörper (11) als Keramikkörper, als passivierter Siliziumkörper oder als passivierter metallischer Körper ausgebildet istund, bei dem der zumindest eine Metallkörper (15) zumindest einen der Bestandteile Au, Ag oder Ni aufweist.

9. Optoelektronisches Bauelement (10) nach einem der vorstehenden Ansprüche, bei dem der zumindest eine Metallkörper (15) als Reflektor ausgebildet ist, zum Reflektieren der elektromagnetischen Strahlung in eine vorgegebene Abstrahlrichtung.

10. Optoelektronisches Bauelement (10) nach einem der vorstehenden Ansprüche, das eine Konverterschicht (20a) mit zumindest einem Leuchtstoff aufweist, die auf zumindest einem Bereich der dem Grundkörper (11) abgewandten Oberfläche der Schichtenfolge (17) aufgebracht ist und mit dem zumindest einen Metallkörper (15) in wärmeleitenden Kontakt steht.

11. Optoelektronisches Bauelement (10) nach einem der vorstehenden Ansprüche, das eine Konverterkeramik (20b) mit zumindest einem Leuchtstoff aufweist, die auf zumindest einem Bereich der dem Grundkörper (11) abgewandten Oberfläche des Metallkörpers (15) aufgebracht ist und mit dem zumindest einen Metallkörper (15) in wärmeleitenden Kontakt steht.

12. Optoelektronisches Bauelement nach einem der vorstehenden Ansprüche, bei dem der Metallkörper (15) eine dem Grundkörper (11) abgewandte Seite der Schichtenfolge (17) zumindest teilweise nicht bedeckt.

13. Optoelektronisches Bauelement nach einem der vorstehenden Ansprüche, bei dem der Metallkörper (15) ringförmig ausgebildet ist.

14. Optoelektronisches Bauelement nach einem der vorstehenden Ansprüche, bei dem der Metallkörper (15) als Metallumrandung ausgebildet ist, der alle vier Seitenflächen der Schichtenfolge (17) umrandet.

## Claims

1. Optoelectronic component (10) comprising at least one metal body (15) and a layer sequence (17), which is applied on a base body (11) and which is designed to emit an electromagnetic radiation and in which an insulation (12) is applied, on at least one side area, wherein the at least one metal body (15) is applied to at least one region of the insulation (12) and is embodied in such a way that it is in thermally conductive contact with the base body (11), wherein in the layer sequence (17) in operation heat is generated which is dissipated into the base body (11) via the metal body (15).

2. Optoelectronic component (10) according to Claim 1, wherein the insulation (12) is embodied as an insulation layer or as an insulation layer sequence.

3. Optoelectronic component (10) according to Claim 2, wherein the insulation layer or the insulation layer sequence has a passivation layer and/or at least one air layer.

4. Optoelectronic component (10) according to any of the preceding claims, wherein the at least one metal body (15) is embodied as a metal mask (40).

5. Optoelectronic component (10) according to any of the preceding claims, wherein the at least one metal body (15) is produced by means of an electrolytic method.

6. Optoelectronic component (10) according to any of the preceding claims, wherein a current distribution structure (14) is applied to at least one region of a surface of the layer sequence (17) which is remote from the base body (11).

7. Optoelectronic component (10) according to Claim 6, wherein the at least one metal body (15) is in electrically conductive contact with the current distribution structure (14) and with an electrical connection region (16) for making electrical contact with the optoelectronic component (10).

8. Optoelectronic component (10) according to any of the preceding claims, wherein the base body (11) is embodied as a ceramic body, as a passivated silicon body or as a passivated metallic body and wherein the at least one metal body (15) comprises at least one of the constituents Au, Ag or Ni.

9. Optoelectronic component (10) according to any of the preceding claims, wherein the at least one metal body (15) is embodied as a reflector, for reflecting the electromagnetic radiation in a predefined emission direction.

10. Optoelectronic component (10) according to any of the preceding claims, which has a converter layer (20a) comprising at least one phosphor, said converter layer being applied on at least one region of that surface of the layer sequence (17) which is remote from the base body (11), and being in thermally conductive contact with the at least one metal body (15).

11. Optoelectronic component (10) according to any of the preceding claims, which has a converter ceramic (20b) comprising at least one phosphor, said converter ceramic being applied on at least one region of that surface of the metal body (15) which is remote from the base body (11), and being in thermally conductive contact with the at least one metal body (15).

12. Optoelectronic component according to any of the preceding claims, wherein the metal body (15) at least partially does not cover a side of the layer sequence (17) which is remote from the base body (11).

13. Optoelectronic component according to any of the preceding claims, wherein the metal body (15) is embodied in a ring-shaped fashion.

14. Optoelectronic component according to any of the preceding claims, wherein the metal body (15) is embodied as a metal border which borders all four side areas of the layer sequence (17).

## Revendications

1. Composant optoélectronique (10) comportant au moins un corps métallique (15) et une succession de couches (17) qui est déposée sur un corps de base (11) et est conçu pour émettre un rayonnement électromagnétique et dans lequel une isolation (12) est déposée sur au moins une surface latérale, dans lequel l'au moins un corps métallique (15) est déposé sur au moins une zone de l'isolation (12) et est conçu de manière à être mis en contact thermiquement conducteur avec le bord de base (11), dans lequel, lors du fonctionnement, de la chaleur est produite dans la succession de couches (17), laquelle chaleur est dissipée par l'intermédiaire du corps métallique (15) dans le corps de base (11).

2. Composant optoélectronique (10) selon la revendication 1, dans lequel l'isolation (12) est réalisée sous la forme d'une couche d'isolation ou d'une succession de couches d'isolation.

3. Composant optoélectronique (10) selon la revendication 2, dans lequel la couche d'isolation ou la succession de couches d'isolation comporte une couche de passivation et/ou au moins une couche d'air.

4. Composant optoélectronique (10) selon l'une quelconque des revendications précédentes, dans lequel l'au moins un corps métallique (15) est réalisé sous la forme d'un masque métallique (40).

5. Composant optoélectronique (10) selon l'une quelconque des revendications précédentes, dans lequel l'au moins un corps métallique (15) est réalisé au moyen d'un procédé galvanique.

6. Composant optoélectronique (10) selon l'une quelconque des revendications précédentes, dans lequel une structure de répartition de courant (14) est déposée sur au moins un zone d'une surface de la succession de couches (17) qui est tournée en direction opposée au corps de base (11).

7. Composant optoélectronique (10) selon la revendication 6, dans lequel l'au moins un corps métallique (15) est en contact électriquement conducteur avec la structure de répartition de courant (14) et avec une zone de connexion électrique (16) pour établir un contact électrique avec le composant optoélectronique (10).

8. Composant optoélectronique (10) selon l'une quelconque des revendications précédentes, dans lequel le corps de base (11) est réalisé sous la forme d'un corps de silicium passivé ou d'un corps métallique passivé et dans lequel l'au moins un corps métallique (15) comporte au moins l'un des constituants Au, Ag ou Ni.

9. Composant optoélectronique (10) selon l'une quelconque des revendications précédentes, dans lequel l'au moins un corps métallique (15) est réalisé sous la forme d'un réflecteur destiné à réfléchir le rayonnement électromagnétique dans une direction de rayonnement prédéterminée.

10. Composant optoélectronique (10) selon l'une quelconque des revendications précédentes, comportant une couche de conversion (20a) comprenant au moins un matériau luminescent qui est déposé sur au moins une zone de la surface de la succession de couches (17) qui est tournée en direction opposée au corps de base (11) et est en contact thermiquement conducteur avec l'au moins un corps métallique (15).

11. Composant optoélectronique (10) selon l'une quelconque des revendications précédentes, comportant au moins une céramique de conversion (20b) comprenant au moins un matériau luminescent qui est déposé sur au moins une zone de la surface du corps métallique (15) qui est tournée en direction opposée au corps de base (11) et est en contact thermiquement conducteur avec l'au moins un corps métallique (15).

12. Composant optoélectronique selon l'une quelconque des revendications précédentes, dans lequel le corps métallique (15) ne recouvre pas au moins partiellement une face de la succession de couches (17) qui est tournée en direction opposée au corps de base (11).

13. Composant optoélectronique selon l'une quelconque des revendications précédentes, dans lequel le corps métallique (15) est réalisé de manière à présenter une forme annulaire.

14. Composant optoélectronique selon l'une quelconque des revendications précédentes, dans lequel le corps métallique (15) est réalisé sous la forme d'une bordure métallique qui entoure la totalité des quatre surfaces latérales de la succession de couches (17).
